(19) Europäisches Patentamt
European Patent Office
Office européen des brevets

(11) **EP 4 703 749 A1**

(12) **EUROPEAN PATENT APPLICATION**

(43) Date of publication:
**04.03.2026 Bulletin 2026/10**

(21) Application number: **24221254.6**

(22) Date of filing: **18.12.2024**

(51) International Patent Classification (IPC):
**G01R 31/371** (2019.01)     **G01R 31/392** (2019.01)

(52) Cooperative Patent Classification (CPC):
**G01R 31/392; G01R 31/371**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **29.08.2024 US 202463688640 P**

(71) Applicant: **The Penn State Research Foundation University Park, PA 16802 (US)**

(72) Inventors:
• **Rahn, Christopher D.**
  **University Park, 16802 (US)**
• **Shariatmadari, Mohammadreza**
  **University Park, 16802 (US)**

(74) Representative: **Schaafhausen, Anne**
**Schaafhausen Patentanwälte PartGmbB**
**Prinzregentenplatz 15**
**81675 München (DE)**

(54) **BATTERY STATE OF HEALTH ESTIMATION USING ONBOARD AND REMOTE BATTERY MONITOR APPARATUS**

(57)     Methods and systems for estimating a state of health (SOH) of a battery (12) of an e-micromobility vehicle (10) can include collecting sensor data of the battery (12) during a plurality of compression periods, wherein the sensor data includes voltage data, current data, and/or temperature data. The sensor data can be compressed and the compressed data can be transmitted to an external device (30, 32, 34), such as a server or user device, where the compressed data may be used to estimate the state of health of a battery.

**FIG. 1**

## Description

### TECHNICAL FIELD

Embodiments relate to a battery management system for monitoring a battery in a vehicle, and a method for estimating battery state of health and other parameters using such battery management system. In particular, embodiments relate to a battery management system for monitoring a battery of an e-micromobility vehicle (e.g. battery powered golf cart, e-bike, e-skateboard, e-scooter, etc.) with utilization of on-board data collection and remote, off-board data analysis and evaluation.

### BACKGROUND

The electrification of transportation networks has undergone significant development in recent years. Coupled with clean energy sources, electric vehicles (EVs) such as EV cars, EV trucks, and other EVs can drastically reduce global greenhouse gas emissions. Battery technology plays a major role in facilitating this transition by providing dependable and secure energy sources for electric macro and micro mobility vehicles.

In addition to EVs, e-micromobility (EMM) vehicles are utilized by people for urban mobility (e.g. e-bikes, e-scooters, e-skateboards, golf carts that are battery powered and recharged via electrical recharging, etc.). EEM vehicles are different than EVs such as EV automobiles. EEM vehicles are substantially smaller, have a substantially smaller battery, and are designed to run on a battery for a much shorter time and for a much smaller distance (e.g. 1-2 hours instead of days, travel distance of 5-15 miles instead of hundreds of miles, etc.). Different types of EMM vehicles have been widely adopted in metropolitan areas due to traffic congestion, reduced environmental footprint, and their lower cost.

### SUMMARY

During battery use, numerous destructive side reactions contribute to internal degradation mechanisms that gradually increase internal resistance and capacity loss, among other effects. Consequently, as a battery ages, it may no longer be able to deliver the required power and voltage. The batteries of EMM vehicles are often charged inside buildings and have been responsible for fires and fatalities. Thus, assessing the state of health (SOH) of EMM vehicle batteries is important to ensure safe operation and monitor their natural degradation over time. In particular, EMM vehicles pose considerable SOH estimation challenges because their battery management systems (BMS) have limited computation power, memory, and communication bandwidth due to the low cost of EMM vehicles.

The SOH of a battery is an intrinsic characteristic of a battery of an EMM vehicle that cannot be directly measured. Rather, it must be estimated using factors such as internal resistance and capacity estimates, which may typically be generated from voltage and current time histories. SOH estimation approaches can be classified into three main categories: Data-driven methods, model-based methods, and direct-measurement methods.

Data-driven methods establish a mapping model between SOH and health-related features of the battery. These features are extracted from large amounts of measured battery data (e.g., voltage and current time histories), processed using, e.g., incremental capacity and differential voltage methods, and then used to train the estimation model via techniques like support vector machines, fuzzy logic, and artificial neural networks. The training process requires considerable memory and computational power, so the practical implementation of data-driven methods in SOH estimation for relatively inexpensive EMM vehicles could be limited. Moreover, the mapping model implicitly estimates SOH and may not provide insights on the underlying aging mechanisms or the trends in resistance rise and capacity fade.

Model-based methods use a mathematical model that approximates the dynamic behavior of the battery voltage given the current input. Electrochemical, empirical, and equivalent circuit models (ECM) have parameters related to SOH that can be estimated. Model parameters and SOH estimation algorithms include fitting methods, optimization algorithms, least squares estimation, and filter-based approaches such as the Kalman filter and its variations. In comparison to data-driven methods, model-based SOH estimation techniques typically produce high accuracy with a smaller data set and are suitable for real-time on-board implementation. However, the required computational power can be too expensive for a typical EMM BMS, especially if a high order model is needed for accurate SOH estimation.

In applications such as EMM vehicles with strict design constraints on size, cost, computational process power, and data storage, SOH estimation may not be feasible with data-driven and model-based methods. Connecting the BMS to a cloud server with vast memory and computation power is possible, but the cost of transmitting finely sampled data to the cloud in order to achieve high accuracy may be prohibitive.

Direct measurement-based methods, the third category of SOH estimation approaches, involve calculating SOH-related parameters directly from experimental data, typically obtained from current and voltage measurements. These methods can be straightforward to implement and do not demand significant computational resources but produce relatively poor estimates of SOH, due to their limited sophistication.

We have developed a new process that can be implemented to estimate the state of charge (SOC) and SOH (internal resistance and residual capacity) of batteries in low-cost EMM vehicles. This approach can permit collected data concerning voltage data and current data measured on the vehicle at a high sample rate to be compressed, stores the compressed data on-board the vehicle at a low sample rate, and subsequently broadcasts the compressed data to a remote device (e.g., an off-board computer with data storage and computation capabilities) for evaluation of that data periodically when the battery is communicatively connectable to the remote device (e.g. via an internet connection with an access point or paired mobile device, etc.). A battery SOH evaluation process can be defined in code that is to be run by the remote computer device (e.g. smart phone, one or more server computer devices that may host a cloud based service, etc.) for use of the data received from the EEM vehicle's on-board battery health monitor device to calculate a SOH estimate and analyze trends to assess the performance and safety of the EMM. The evaluation result(s) can then be communicated by the remote device to a user (e.g. via sending of a notification to a user's personal device such as a smart phone, tablet, or personal computer) and/or via a notification that may be displayed on the user's personal device when logged into the hosted remote service via a graphical user interface (GUI) to provide valuable feedback to a user concerning the SOH of the EMM vehicle's battery.

In a first aspect, a method of estimating a state of health of a battery of an e-micromobility vehicle is provided. Embodiments of the method can include collecting sensor data of the battery during a plurality of compression periods. The sensor data can include voltage data, current data, and/or temperature data.

The method can also include determining parameter data from the collected sensor data for each compression period, compressing the parameter data on-board the vehicle, and transmitting the compressed parameter data to an external device for analyzing the compressed parameter data to estimate the state of health (SOH) of the battery.

In a second aspect, the external device can be an input/output device, a server, or a charging device. For example, the external device can be a user's smart phone, tablet, or laptop computer. As another example, the external device can be a server that may host a service for estimating the SOH of a battery. As yet another example, the external device can be a computer device or a charging device (e.g. a battery charging station or charging unit, etc.).

In a third aspect, the method can include the external device analyzing the compressed parameter data to estimate the state of health (SOH) of the battery.

In a fourth aspect, the compressed parameter data can be one or more of: maximum voltage ($V_{max}$), minimum voltage ($V_{min}$), current at time of maximum voltage ($I_{max}$), current at time of minimum voltage ($I_{min}$), average current ($\bar{I}$), average temperature ($\bar{T}$), and time ($t$) of the compression period.

In a fifth aspect, the external device can be configured to estimate a state of charge (SOC) of the battery by calculating:

$$\widehat{SOC}[h] = f^{-1}(V_{rest})$$

wherein $\widehat{SOC}$ refers to an estimated state of charge, $h$ refers to a series of compression periods, $f$ refers to an open circuit voltage-SOC (OCV-SOC) curve of the battery, $f^{-1}$ is the inverse function of $f$, and $V_{rest}$ refers to a real-time voltage at the end of a rest period.

In a sixth aspect, a rest period can be identified by a series of compression periods according to:

$$|I_{min}[h]| < \frac{Q}{\eta_1}, \text{ and } |I_{max}[h]| < \frac{Q}{\eta_2}, \text{ and } |\bar{I}[h]| < \frac{Q}{\eta_3}$$

wherein $Q$ refers to nominal capacity, and $n_{1,2,3}$ refer to rest point limits on $|I_{min}|$, $|I_{max}|$, $|\bar{I}|$, respectively.

In a seventh aspect, the external device can be configured to estimate a state of charge (SOC) of the battery by calculating:

$$\widehat{SOC}[h] = 1 + \frac{\sum_{h=1}^{N_c} \bar{I}[h](t[h] - t[h-1])}{\hat{Q}_c}$$

wherein $\widehat{SOC}$ refers to an estimated state of charge, $h$ refers to a series of compression periods, $\hat{Q}_c$ refers to an estimated total capacity, and $N_c$ refers to a number of compression periods.

In an eighth aspect, the external device can be configured to estimate a capacity of the battery ($\hat{Q}_c$) by calculating:

$$\hat{Q}_c = \frac{\sum_{h=h_1}^{h_2} \bar{I}[h](t[h]-t[h-1])}{\widehat{SOC}[h_1]-\widehat{SOC}[h_2]}$$

wherein $\widehat{SOC}$ refers to an estimated state of charge and $h$ refers to a series of compression periods.

In a ninth aspect, the state of health (SOH) can be estimated by calculating:

$$SOH = \frac{\hat{Q}_c}{Q_O} \times 100\%$$

wherein $\hat{Q}_O$ refers to initial capacity *and* $\hat{Q}_c$ refers to current capacity estimate.

In a tenth aspect, the external device can be configured to estimate a resistance of the battery (12) by calculating:

$$\hat{R}_c = \frac{V_{min}[h] - V_{min}[h-1]}{I_{min}[h] - I_{min}[h-1]}$$

wherein $h$ refers to a series of compression periods.

In some embodiments, the state of health can be estimated by calculating:

$$SOH = \frac{R_{EOL} - \hat{R}_C}{R_{EOL} - R_O} \times 100\%$$

wherein $R_{EOL}$ refers to resistance at end of life, $\hat{R}_C$ refers to the resistance estimate at current time, and $R_O$ refers to resistance at an initial time.

In an eleventh aspect, the charging device can adjust charging of the e-micromobility vehicle based on the estimated state of health (SOH).

In a twelfth aspect, the method of the first aspect can include one or more features of the second aspect, third aspect, fourth aspect, fifth aspect, sixth aspect, seventh aspect, eighth aspect, ninth aspect, tenth aspect and/or eleventh aspect. Embodiments can also utilize other features or elements. Examples of such other features or elements can be appreciated from the exemplary embodiments discussed herein, for instance.

In a thirteenth aspect, a system for estimating a state of health (SOH) of a battery of an e-micromobility vehicle is provided. Embodiments of the system can be configured to implement an embodiment of the method of estimating a state of health of a battery of an e-micromobility vehicle.

Some embodiments of the system can include a battery management system comprising a microcontroller unit, a non-transitory computer readable medium connected to the microcontroller unit, a communication unit connected to the microcontroller unit, and a sensor array connected to the microcontroller unit. The sensor array can include a voltage sensor, a current sensor, and a temperature sensor. The sensor array can be configured to collect sensor data of the battery during a plurality of compression periods, wherein the sensor data comprises voltage data, current data, and temperature data collected from the voltage sensor, the current sensor, and the temperature sensor. The battery management system can be configured to determine parameter data from collected sensor data for each compression period and can be configured to compress the parameter data on-board the vehicle to send the compressed data to an external device that is configured to receive the compressed parameter data from the battery management system.

In some embodiments, the battery management system can include a transceiver unit to communicatively connect with the external device for sending the compressed data to the external device.

In a fourteenth aspect, the system can include the external device. The external device can be configured to estimate the state of health (SOH) of the battery. In some embodiments, the external device can be an input/output device, a server, or a charging device.

In a fifteenth aspect, the system can be configured so that the external device includes a charging device and the charging device is configured to adjust charging of the battery of the e-micromobility vehicle based on the state of health estimate.

In a sixteenth aspect, embodiments of the system can include other features or elements. For example, the system of the thirteenth aspect can include one or more features of the fourteenth aspect and/or the fifteenth aspect. As another example, embodiments of the system can include one or more features or elements from exemplary embodiments of the system discussed herein.

Further features, aspects, objects, advantages, and possible applications of the present invention will become apparent from a study of the exemplary embodiments and examples described below, in combination with the Figures, and the appended claims.

## BRIEF DESCRIPTION OF THE DRAWINGS

The above and other objects, aspects, features, advantages, and possible applications of embodiments of the present innovation will be more apparent from the following more particular description thereof, presented in conjunction with the following drawings. Like reference numbers used in the drawings may identify like components.

FIG. 1 is a schematic illustration of an exemplary battery state of health estimation system.

FIG. 2A is a schematic block diagram of an exemplary battery management system configured to estimate battery state of health.

FIG. 2B is a schematic block diagram of an exemplary battery management system configured to estimate battery state of health.

FIG. 3A is a schematic block diagram illustrating an exemplary embodiment of a system for estimating battery state of health.

FIG. 3B is a schematic block diagram illustrating an exemplary embodiment of a system for estimating battery state of health.

FIG. 3C is a schematic block diagram illustrating an exemplary embodiment of a system for estimating battery state of health.

FIG. 4 is a schematic illustration showing an exemplary data compression method.

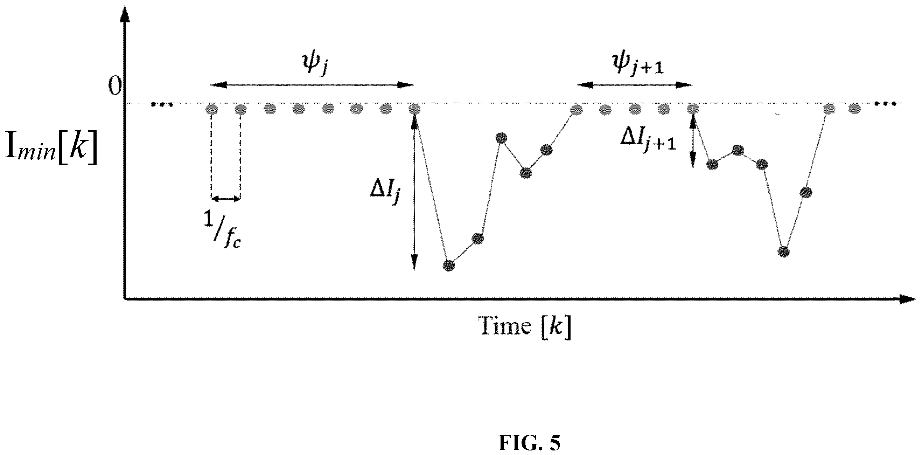

FIG. 5 is a schematic drawing showing exemplary compressed current data with identified rest periods $\psi_j$ and current jumps $\Delta I_j$.

FIG. 6 is a graph showing exemplary current data for a battery at a 5 minute sample rate.

FIG. 7 is a graph showing exemplary voltage data for a battery at a 5 minute sample rate.

FIG. 8 is a graph showing exemplary temperature data for a battery at a 5 minute sample rate.

FIG. 9 is a graph showing exemplary current throughput data for a battery at a 5 minute sample rate.

FIG. 10 is a graph showing an exemplary OCV-SOC curve for a T875-AGM battery at a C-rate of C/3.

FIG. 11 is a graph showing exemplary discharge current data for a battery at a 5 minute sample rate.

FIG. 12 is a graph showing exemplary discharge voltage data for a battery at a 5 minute sample rate.

FIG. 13 shows graphs illustrating estimated capacities for six exemplary batteries over 250 days of use.

FIG. 14 shows graphs illustrating estimated internal resistances for six exemplary batteries over 250 days of use.

FIG. 15 is a plot of measured string voltage $\tilde{V}_{min}$ (represented by circles) vs estimated $\hat{V}_{min}$ (represented by crosses) over 250 days of use.

## DETAILED DESCRIPTION

The following description is of exemplary embodiments and methods of use that are presently contemplated for carrying out the present invention. This description is not to be taken in a limiting sense, but is made merely for the purpose of describing the general principles and features of various aspects of the present invention. The scope of the present invention is not limited by this description.

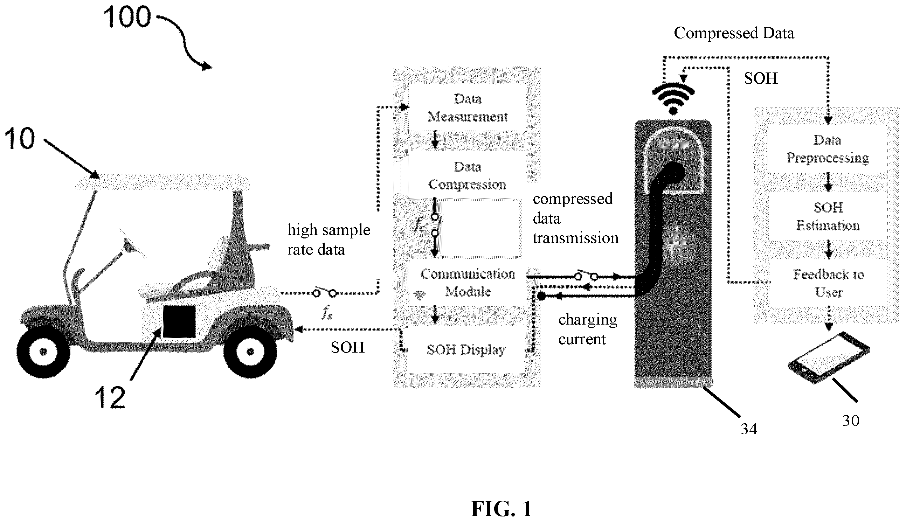

Embodiments relate to a system 100 configured to provide state of health (SOH) estimations of one or more batteries of an e-micromobility (EMM) vehicle. Referring to FIG. 1, an EMM vehicle 10 is typically a small, lightweight, battery-powered vehicle. Exemplary vehicles include, but are not limited to, electric scooters, electric bicycles (e-bikes), electric skateboards, electric mopeds, battery powered golf carts, and battery powered drones. The EMM vehicle 10 can comprise at least one battery pack 12 including at least one battery or battery cell. The term "battery" as used herein should be understood to encompass a battery unit having multiple battery cells, a battery pack having multiple battery cells, an individual battery, and/or an individual battery cell. The battery 12 can be a rechargeable battery.

The battery 12 can be arranged in the EEM vehicle 10 to store electrical energy that can be used to deliver power (e.g. electrical energy, voltage, current, etc.) to power the vehicle 10. Exemplary batteries include, but are not limited to, lead acid batteries, lithium-ion batteries, nickelmetal hydride batteries, solid-state batteries, lithium iron phosphate batteries, lithium manganese oxide batteries, or any other suitable battery. The battery 12 is preferably a rechargeable battery such that it can store electrical energy that can be replenished after at least a portion of the energy has been depleted via an electrical connection with an electrical outlet or other type of electrical charging station.

The EMM vehicle 10 can further comprise a battery management system (BMS) 14. The BMS 14 can be electrically connected to the battery 12 and be configured to manage and/or monitor the performance of the battery 12. For example, the BMS 14 can be configured to monitor various parameters of the battery 12, including but not limited voltage, current, and temperature. As an EMM vehicle 10 is typically small in size, embodiments of the BMS 14 can be designed and configured to have a relatively simple design that has limited computation power, memory, and communication bandwidth. For example, elements of the BMS can be provided on a single processing board (e.g. printed circuit board) and be sized and configured for utilization in an EMM vehicle to provide a small, low-cost feature for the EMM vehicle.

The BMS 14 can include a plurality of electrical hardware components, such as a microcontroller unit 16 that is connected to non-transitory memory 18 or other type of non-transitory computer readable medium, a communication unit 20 (e.g. at least one wireless communication transceiver), and a sensor array 22 comprising at least one sensor (e.g. a current sensor, a voltage sensor, a temperature sensor, etc.). The microcontroller unit 16 can be a type of processor or central processing unit, for example.

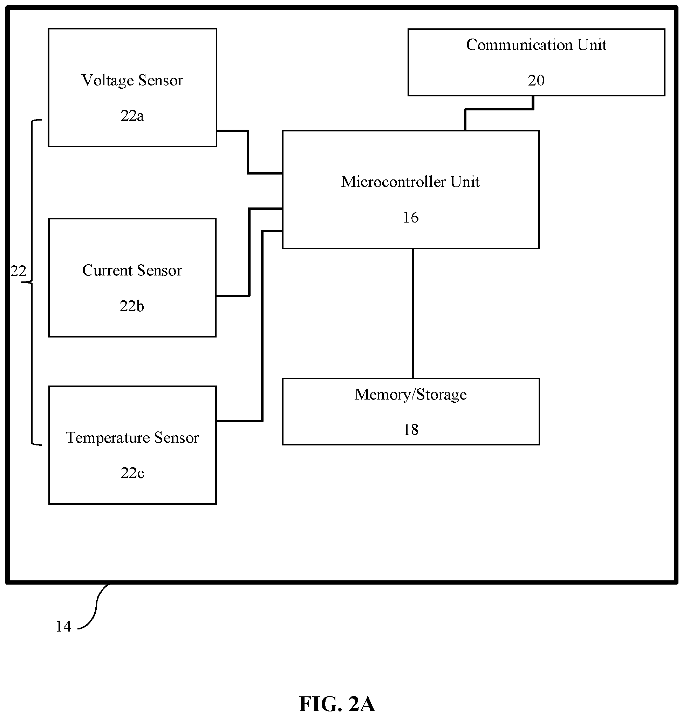

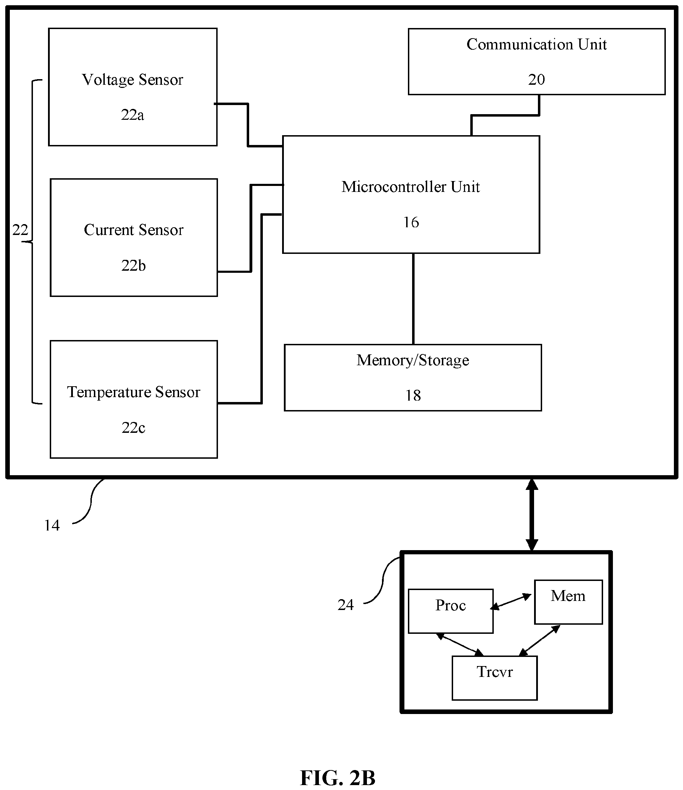

As seen in FIGS. 2A-2B, the microcontroller unit 16 can interface with the rest of the electrical components of the BMS 14. As the BMS 14 is electrically connected to the battery 12, the BMS 14 can therefore draw power to supply the electrical components with required electricity. Preferred embodiments of the vehicle 10 disclosed herein can include low power electrical components, as these can allow for an elongated period of time in which the battery 12 can provide a source of power to the vehicle 10 before requiring recharging.

The sensor array 22 comprising at least one sensor can be configured to collect sensor data. Each of the sensors of the sensor array 22 can be configured to detect or measure at least one parameter of the battery 12. The sensors of the sensor array 22 can be communicatively connected to the microcontroller unit 16, non-transitory memory 18, and/or other non-transitory computer readable medium such that the sensors interface with and provide data to the microcontroller unit 16, non-transitory memory 18, and/or other non-transitory computer readable medium.

The sensor array 22 can include a number of different sensors. In some embodiments, the sensor array 22 can comprise at least one voltage sensor 22a configured to measure the voltage of a battery 12. The sensor array 22 can further comprise at least one current sensor 22b configured to measure the current flowing in and out of a battery 12. The sensor array 22 can further comprise at least one temperature sensor 22c configured to measure the temperature of a battery 12. Embodiments of the sensor array 22 can include only one such sensor, a combination of two or more of such sensors, or all three of such sensors in different embodiments. The sensor array 22 can also include batteries with voltage, temperature, and/or current sensors for every cell in the battery.

Each of the voltage sensor 22a, current sensor 22b, and temperature sensor 22c can interface with and provide data to the microcontroller unit 16, non-transitory memory 18, and/or other non-transitory computer readable medium. The data received from each sensor can be compressed for storage via a data compression process in accordance with a pre-defined sensor data compression protocol to be utilized by the BMS 14.

In exemplary embodiments, the sensor array 22 can be configured to collect data at a high frequency (e.g., collect data at a high sampling rate that can utilize a sampling rate interval of between one second and one minute, collect data a high sampling rate that can utilize a sampling rate interval of between 0.5 seconds and 30 seconds, etc.). In some embodiments, the sensor array 22 can be configured to collect at least current data and voltage data at a high frequency. In some embodiments, the sensor array 22 can continuously collect data at a high frequency sampling rate. In other embodiments, the sensor array 22 can periodically collect data (e.g., non-continuously at predetermined intervals or not when the EMM is idle).

The collected data can then be compressed on-board the vehicle 10 during one or more compression periods. A compression period is a predetermined period of time in which at least current data and voltage data is collected and subsequently compressed. Temperature data (when collected) can also be compressed as well. There can be a plurality of high-frequency samples ($N_s$) in each compression period. A compression period is therefore longer than the data collection period, and can range from one minute to one hour (e.g. can be about 5 minutes, can be between 1 minute and 5 minutes, etc.) or other suitable time period. The data compression can advantageously reduce the amount of storage space required to store data on the vehicle and/or enable faster transmission of data that requires less bandwidth and/or time for the data transmission.

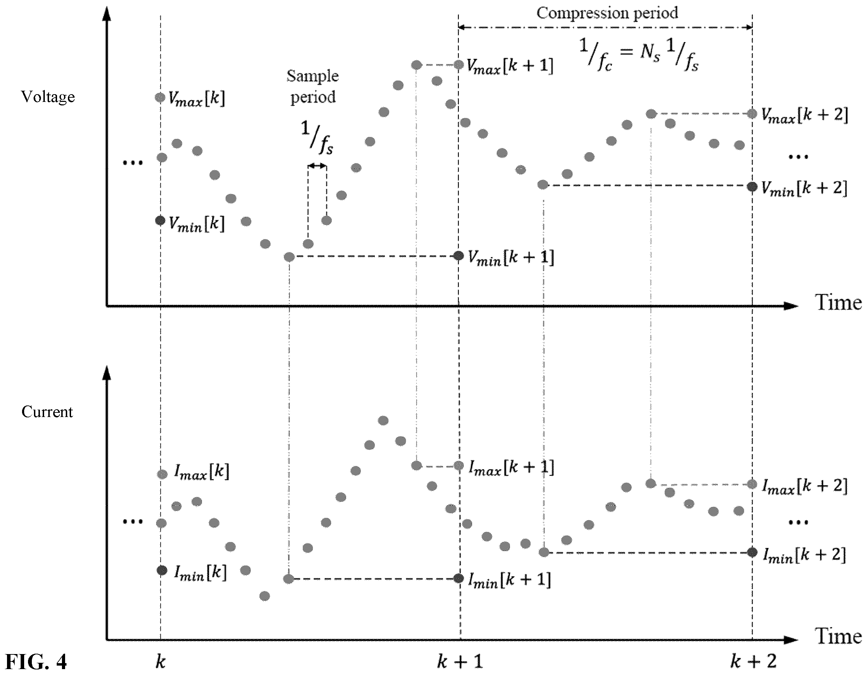

In exemplary embodiments, for each compression period, various parameters can be derived from the collected data (e.g., the current data, voltage data, and temperature data) and can be compressed. For example, the maximum voltage ($V_{max}$) and minimum voltage ($V_{min}$), the current at the time of capturing the maximum voltage ($I_{max}$), the current at the time of capturing the minimum voltage ($I_{min}$), and the average current ($\bar{I}$) within each compression period can be determined as compressed parameters for each compression period (see, e.g., FIG. 4). At the end of each compression period, the Temperature (T) and time (t) can also be recorded as compressed parameters or compressed data parameters (e.g. compressed temperature data and compressed time data).

In some embodiments, the compressed data can include the collected data (e.g., current data, voltage data, etc.) and derived parameters (e.g., the compressed parameters defined above such as the compressed temperature data and the compressed time data). In other embodiments, the compressed data can include only derived parameters, such that the collected data can only serve as buffer data that is temporarily stored to allow for derivation of parameters.

The compressed data can be stored on-board the vehicle, such as within the non-transitory memory 18. In some embodiments, the on-board storage requirements can be limited to a buffer of the $N_s$ collected current and/or voltage data, wherein $N_s$ refers to the number of high-frequency samples collected during a compression period, and the compressed data values (e.g., $Vm_{ax}[h]$, $V_{min}[h]$, $I_{max}[h]$, $I_{min}[h]$, $\bar{I}[h]$, $T[h]$, $t[h]$, for $h$=1, ..., $N_C$, wherein $h$ refers to a compressed data index and $N_C$ refers to the number of compressed periods in a transmission period).

The stored data can then be transmitted from the vehicle 10 to an external, remote device (e.g. smart phone, laptop computer, server, etc.), as will be described in further detail below. In particular, all or at least some of the stored data falling within a transmission period can be transmitted. There are several compressed periods ($N_c$) in a transmission period. A transmission period is therefore longer than the compression period (e.g. once per day, at every charging event, etc.), and can be defined as a period of time since the most recent previous transmission period, or can be defined as any other predetermined time period.

In some embodiments, the stored data can be transmitted to an external device by the BMS 14 (e.g., by the microcontroller unit 16) via the communication unit 20. The communication unit 20 can be configured as a wireless interface for the transmission of the stored compressed data via a wireless connection with an external apparatus. For example, the communication unit 20 can be a Bluetooth Low Energy (BLE) system coupled to the microcontroller 16 to facilitate Bluetooth wireless communications with an external communication device or a wireless network transceiver (e.g. cellular transceiver, Wi-Fi transceiver, etc.) for connection with a local area network or cellular network for communicating data to a remote device. The communication unit 20 can also, or alternatively, be configured as a wired interface for the transmission of stored compressed data via a wired connection with an external, remote device.

In some embodiments, the vehicle 10 can have an internet of things (IOT) device 24 embedded or in operative connection with the battery 12. The IOT device 24 can be configured to receive, compress, and store data in the same manner as described above with respect to the BMS 14. The IOT device 24 can further be configured to transmit stored data to an external, remote device in the same manner as described above with respect to the BMS 14. The IOT device 24 can be a computer device that has at least one processor (Proc) connected to at least one non-transitory computer readable medium (e.g., memory, a hard drive, etc.) (Mem) and at least one transceiver unit (e.g., a network transceiver, etc.) (Trcvr).

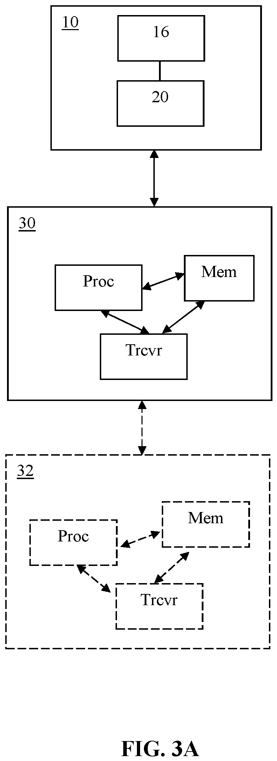

In one embodiment, referring to FIG. 3A, the stored data is transmitted to at least one input/output device 30. The input/output device 30 can be a computer device (e.g., a smart phone, a laptop computer, a tablet, etc.) that has at least one processor (Proc) connected to at least one non-transitory computer readable medium (e.g., memory, a hard drive, etc.) (Mem) and at least one transceiver unit (e.g., a network transceiver, etc.) (Trcvr).

The stored data can alternatively or subsequently be sent to a server 32 that can be connected to the input/output device 30 (e.g., via a network connection). The forwarding of the stored data can be provided via a communication connection that the vehicle 10 directly has with an input/output device 30 such that stored data is sent to the server 32 via the input/output device 30. Either the input/output device 30 or the server 32 can be configured to further store the data. As the vehicle 10, and particularly its BMS 14, can have strict constraints on cost, computation process power, data storage, etc., the input/output device 30 and/or the server 32 can have vast memory and/or computation power to overcome the limitations of the vehicle 10 and/or its BMS 14.

It should be appreciated that the server 32 can include a computer device that can be configured as a cloud based server that can have at least one processor (Proc) connected to at least one non-transitory computer readable medium (e.g., memory, a hard drive, etc.) (Mem), and can further have at least one transceiver unit (e.g., a network transceiver, etc.) (Trcvr). The server 32 can be configured to host a battery SOH evaluation service that can be communicatively accessible via a communication connection that a user communication device can have with the server(s) 32 that host that service.

In some embodiments, the stored data can be transmitted to the at least one input/output device 30 according to predetermined time intervals (e.g., once per day, once per week, once per month, etc.) or according to the occurrence of one or more pre-defined trigger events. A trigger event can be charging of the vehicle 10, powering off of the vehicle 10, and/or or any other event that can suitably serve as a trigger event. The transmission of the data can be actuated in response to detection of the trigger event(s).

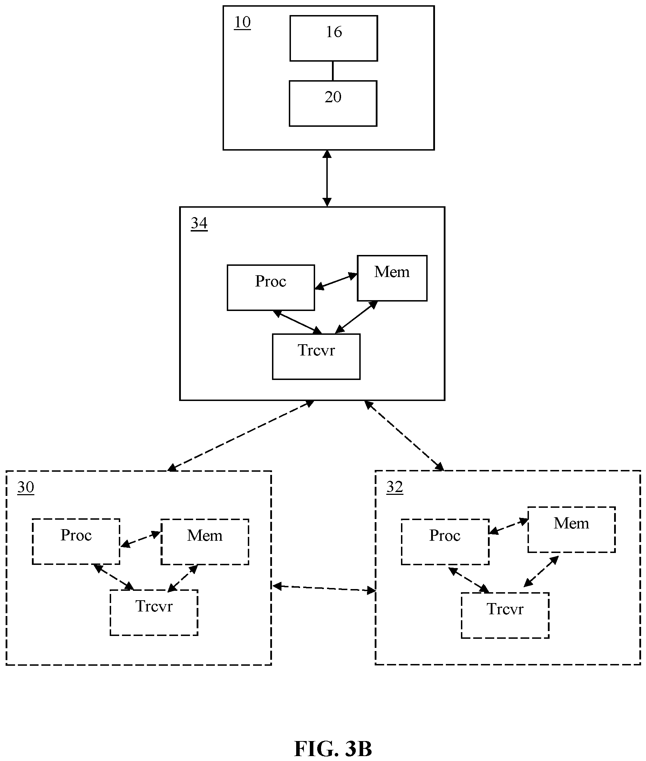

In another embodiment, referring to FIG. 3B, the stored data can be transmitted to at least one charging device 34. The charging device 34 can be a designated external power source configured to charge or recharge the battery 12 of the vehicle 10, such as a home charging station or public charging station. The charging device 34 can have at least one processor (Proc) connected to at least one non-transitory computer readable medium (e.g., memory, a hard drive, etc.) (Mem) and at least one transceiver unit (e.g., a network transceiver, etc.) (Trcvr). In some embodiments, the stored data can be transmitted to the charging device 34 every time the vehicle 10 is being charged.

The stored data received by the charging device 34 can subsequently be sent to a server 32 that can be connected to the charging device 34 (e.g., via a network connection, etc.) in some embodiments. The forwarding of the stored data can be provided via a communication connection that the vehicle 10 directly has with a charging device 34 such that stored data is sent to the server 32 via the charging device 34. Either the charging device 34 or the server 32 can be configured to further store the data. As the vehicle 10, and particularly its BMS 14, can have strict constraints on cost, computation process power, data storage, etc., the charging device 34 and/or the server 32 can have vast memory and/or computation power to overcome the limitations of the vehicle 10. The server 32 can subsequently send the data to an input/output device 30.

In some embodiments, the stored data can be transmitted to the charging device 34 as the vehicle 10 is being recharged, such as every time the vehicle 10 is recharged.

In some embodiments, the stored data is transmitted to at least one charging device 34, which can subsequently send the stored data to at least one input/output device 30 (e.g. via a network connection, etc.), which can subsequently send the stored compressed data to a server 32 (e.g. via a network connection, etc.).

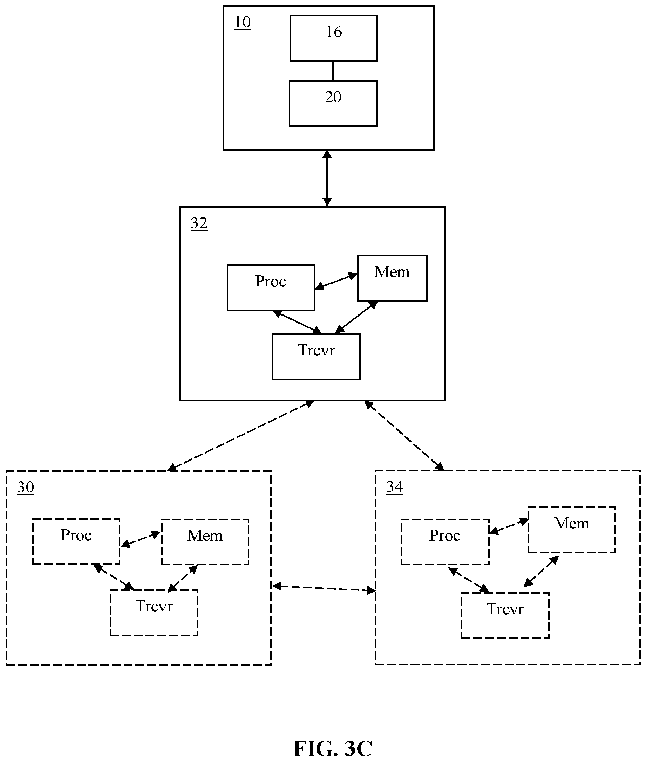

In yet another embodiment, referring to FIG. 3C, the stored data can be transmitted to at least one server 32. The stored data can then subsequently be sent to an input/output device 30 that can be connected to the server 32 (e.g., via a network connection). The stored data can subsequently or alternatively be sent to a charging device 34 that can be connected to the server 32 and/or input/output device 30 (e.g., via a network connection).

Once the data is transmitted to the input/output device 30, the server 32, and/or the charging device 34, the data can be analyzed and evaluated. Data analysis and evaluation can therefore be performed off-board the vehicle 10. For example, the data can be processed using processors, algorithms, machine learning algorithms, or artificial intelligence stored on the input/output device 30, the server 32, and/or the charging device 34.

The output for the processed data or notifications related to the processed data can be communicated to the user via one or more notifications and/or generation of a graphical user interface (GUI) or GUI element that can be communicated to a user device (e.g. the user's input/output device 30, etc.). In embodiments where the charging device 34 or the server 32 can perform the processing, such a GUI and/or notifications can be provided via an application programming interface (API) or other interface the user's input/output device 30 may have with the server 32 and/or charging device, for example. The notifications can include providing a notification about a determine status of health of the battery, a state of the charge of the batter, or a notification indicating that the battery status is below a pre-selected safety threshold and requires replacement and should not undergo further recharging to help avoid a potentially hazardous condition (e.g. possible fire, etc.).

The notifications can be sent in response to determination made from compressed data that may be sent from the BMS 14 to an external device (e.g. server, user device, charging station, etc.) and the evaluation of that data to determine the battery health parameter(s) that are the subject of the notifications. The notifications can be pre-defined notifications to be issued or sent in response to a pre-selected threshold being determined from the compressed data, for example. The notifications can include messages pushed to a user's device and/or graphical icons or other output that may be provided to a user device after the user device sends a request for such data to another device (e.g. a server 32, etc.).

In some exemplary embodiments, analysis and evaluation of the sensor data can include estimating the state of charge (SOC) of the battery 12. SOC represents the current energy level of a battery 12, and is a measure of the current charge level of the battery 12 compared to its total capacity. For example, a battery with an SOC of 100% is fully charged, while a battery with an SoC of 0% is completely discharged. Knowing SOC can facilitate determining how much longer a vehicle 10 can operate before needing to be recharged, and monitoring SOC can help in managing battery health, preventing overcharging and deep discharging, which can reduce battery lifespan.

In particular, SOC can correlate to the open circuit voltage (OCV) of a battery 12 at rest, such as when the battery 12 is not being charged or discharged. Therefore, SOC can be determined if an OCV-SOC curve is known, voltage is measurable, and the battery 14 has neither been charged or discharged during a compression period. Rest periods can be identified by a series of compression periods (h) according to Equation (1):

$$|I_{min}[h]| < \frac{Q}{\eta_1}, \text{ and } |I_{max}[h]| < \frac{Q}{\eta_2}, \text{ and } |\bar{I}[h]| < \frac{Q}{\eta_3} \tag{1}$$

wherein $I_{min}$ is the current at the time of capturing the minimum voltage, $I_{max}$ is the current at the time of capturing the maximum voltage, and $\bar{I}$ is the average current. Moreover, Q is nominal capacity, and $n_{1,2,3}$ are rest point limits on $|I_{min}|$, $|I_{max}|$, $|\bar{I}|$, respectively, and can be tuned for specific application operating conditions. The SOC estimate can be calculated according to Equation (2):

$$\widehat{SOC}[h] = f^{-1}(V_{rest}) \tag{2}$$

wherein $V_{rest}$ is real-time voltage at the end of a rest period and $f$ is the OCV-SOC curve associated with the average C-rate (e.g., a measure of the rate at which a battery is discharged relative to its capacity) and average temperature for typical rest periods and $f^{-1}$ is the inverse function of $f$. SOC can be estimated in accordance with the above approach and implemented off-board the vehicle 10 with sparsely sampled data as described above, thereby unburdening the BMS 14.

Alternatively, SOC can be estimated from current integration via Equation (3):

$$\widehat{SOC}(t) = \frac{\hat{Q}_c + \int_0^t I(t)dt}{\hat{Q}_c} = 1 - \widehat{DOD}(t) \tag{3}$$

wherein $I$ is the current during discharge (and $I(t) < 0$), $\hat{Q}_c$ is the estimated total capacity, and DOD is the depth of discharge. Equation (3) can be computed off-board the vehicle 10 with sparsely sampled data as described above, via Equation (4):

$$\widehat{SOC}[h] = 1 + \frac{\sum_{h=1}^{N_c} \bar{I}[h](t[h]-t[h-1])}{\hat{Q}_c} \tag{4}$$

In one embodiment, analysis and evaluation of the data can include estimating capacity of the battery 12. Capacity can be assumed to vary slowly over time, so estimating one estimation per discharge cycle can be sufficient. If there are two rest points during the discharge cycle with $\widehat{SOC}[h_1]$ and $\widehat{SOC}[h_2]$, capacity can be estimated according to Equation (5):

$$\hat{Q}_c = \frac{\sum_{h=h_1}^{h_2} \bar{I}[h](t[h]-t[h-1])}{\widehat{SOC}[h_1] - \widehat{SOC}[h_2]} = \frac{\Delta Ah}{\Delta \widehat{SOC}} \tag{5}$$

wherein $\Delta Ah$ is the change in ampere-hours ($Ah$), which is a unit of electric charge used to describe the capacity of a battery. Capacity estimation error can be minimized by selecting rest points with maximum $SOC$ differences, such as choosing rest points near the beginning and end of a discharge cycle.

In one embodiment, analysis and evaluation of the data can include estimating impedance of the battery 12. In particular, the immediate response of a battery voltage to a sudden step change in current can be used to estimate impedance, which can be an important factor in the ability for the battery 12 to provide power. Impedance rise can often be used as an SOH indication. With voltage and current measurements, impedance can be estimated at the start of large current pulses using change in voltages and currents according to Equation (6):

$$\hat{R}_c = \frac{\Delta I}{\Delta V} \tag{6}$$

For off-board calculations, compressed parameters can be used according to Equation (7), assuming the vehicle 10 initiates movement after a rest period:

$$\hat{R}_c = \frac{V_{min}[h] - V_{min}[h-1]}{I_{min}[h] - I_{min}[h-1]} \tag{7}$$

In one embodiment, analysis and evaluation of the data can include predicting minimum voltage of the battery 12. A vehicle can stall if string voltage drops below a minimum voltage limit, typically at low SOC. To validate the accuracy of $\hat{R}$ and $\hat{Q}$ estimation, as described above, an Ohmic battery model can predict:

$$\hat{V}_{min}[l] = \sum_{i=1}^{N}(f\left(1 - \frac{\int_0^{\tilde{t}_{min}} I(\tau)d\tau}{\hat{Q}_c^{(i)}[l]}\right) - \hat{R}_c^{(i)}[l] \cdot \tilde{I}_{min}[l]) \tag{8}$$

wherein $l$ refers to cycle number, such as one cycle per day, $N$ is the number of batteries in a pack (or string), and $\tilde{t}_{min}$ is the time at the minimum voltage of the cycle ($\tilde{V}_{min}$). $\hat{Q}_c^{(i)}[h]$ and $\hat{R}_c^{(i)}[h]$ can be obtained from linear fits of the estimated capacity and resistance values for the $i^{th}$ battery in a pack or string.

In one embodiment, analysis and evaluation of the data can further estimating state of health (SOH) of the battery 12. SOH is an intrinsic characteristic that cannot be directly measured, and rather, it must be estimated. Assessing SOH can be important to ensure safe operation and monitor a vehicle's natural degradation over time.

SOH can be defined relative to energy storage capacity, as seen in Equation (9):

$$SOH = \frac{Q_C}{Q_O} \times 100\% \qquad (9)$$

wherein $Q_O$ and $\hat{Q}_c$ are initial capacity and current capacity, respectively.

SOH can alternatively be defined relative to discharge power, as seen in Equation (10):

$$SOH = \frac{R_{EOL} - R_C}{R_{EOL} - R_O} \times 100\% \qquad (10)$$

wherein $R_{EOL}$, $R_c$, and $R_O$ are discharge resistance of the battery at end of life ($R_{EOL}$), resistance of the battery at the current time ($R_c$), and resistance of the battery at the initial time ($R_O$).

In some embodiments, the input/output device 30, the server 32, and/or the charging device 34 can comprise a graphical user interface (GUI) or some other communication module for providing information to the user regarding data, analysis and evaluation of the data, and/or determined parameters (e.g. calculated or estimated parameters). For example, the vehicle 10 can transmit data collected from the sensor array 22 to the input/output device 30, the server 32, and/or the charging device 34 for data analysis, and the data analysis and evaluation of the data performed by that remote device can subsequently be provided to a user's device to provide information related to the determined parameters can be displayed to the user via a GUI that can be generated on the user's device or other communication module (e.g. text message, email, etc.).

The data included in the notification(s) that can be conveyed to a user concerning the evaluation of the battery's SOH that can be performed by a remote device (e.g. user's smart phone, server that can communicate results of the evaluation of battery SOH data to a user's smart phone, tablet, or other type of personal computer device, etc.) can provide the user with data to indicate that the battery is no longer safe to be recharged to help avoid a possibility of a fire from recharging of the battery of the user's EEM vehicle. The notification(s) can also provide data related to the SOH of the battery to help the user better estimate the duration of use the battery can provide for his or her EEM vehicle based on SOC data for the battery to prevent the user from being surprised when the EEM vehicle becomes low on power or no longer can receive power from the battery 12. The SOH information can also help the user plan for battery replacement.

The data that can be conveyed by the remote device that performs the SOH evaluation of the data collected by the BMS 14 can also include data to be sent to the BMS 14 or other type of controller of the EEM vehicle that can oversee how the battery is utilized and/or managed during use of the EEM vehicle. The transmission of such data can occur directly from the remote device to the EEM vehicle or via at least one intermediate device (e.g. user's device, input/output device 30, charging device 34, etc.). That data can include processing parameter update data for use in updating how the battery recharging and/or conveying of power to the EEM vehicle is performed in accordance with a pre-defined battery utilization process that is utilized by the EEM vehicle. This type of update to the EEM vehicle can permit the vehicle to perform more efficiently and help extend the usable life of its battery 12. For example, the charging profile could be modified based on the battery SOH. The charging profile can include constant current (CC) and constant voltage (CV) phases with different termination conditions. The parameters of these phases (e.g. current during CC charging, voltage during CV charging, and termination voltages, currents, and current rates) can be modified based on the SOH.

The input/output device 30, the server 32, and/or the charging device 34 can be configured to provide feedback to a user. For example, the feedback can be recommended action that the user can take. For example, based on an estimated SOC, the feedback can recommend that a user recharge the battery. As another example, based on an estimated SOH, the feedback can recommend that a user replace the battery.

In some embodiments, a remote computer device (e.g. a remote server or other device) can receive and store data for analysis and/or evaluation of said data from the input/output device 30, the server 32, and/or the charging device 34. A battery manufacturer can access the data via a remote server or other computer device to identify problems with a battery for fixing the battery, recalling the battery, etc. For example, the remote server can collect data from the input/output device 30, the server 32, and/or the charging device 34 for evaluation of the battery data for determining one or more parameters of the battery for one or more different battery models for use in product development and product quality evaluation efforts.

In some embodiments, the server 32 can collect such data and provide that data periodically to a battery manufacturer device that can be communicatively connectable to the server 32. Such data can be pushed to the manufacturer's device or the manufacturer's device can communicatively connect to the server 32 to access the data to analyze it via the server 32 and/or receive the data from the server 32 for use of that data.

**EXAMPLES**

Below are examples of specific embodiments of our apparatus, system, and process. The examples are offered for illustrative purposes only, and are not intended to limit the scope of the present application in any way. Efforts have been made to ensure accuracy with respect to numbers used, but some experimental error and deviation should, of course, be allowed for. While the described EMM vehicle is a golf cart, the described methods and systems and the resulting data can be equally applicable to other types of EMM vehicles (e.g. e-bike, e-scooter, drone, battery powered all-terrain vehicle, etc.).

Experimental data was collected from electrified golf carts that were powered by a battery under real-life usage on golf courses. Each golf cart was equipped with a series string of six 8 V T875-AGM Trojan lead-acid batteries (LABs) with nominal capacity and resistance of 142 Ah (for 10 hours use) and 3 mΩ, respectively. The individual voltage of each LAB, string current, environmental temperature, and time were sampled at 10 Hz. The data was collected by an internet of things (IOT) device that calculates $V$, $V_{max}$, $V_{min}$, $I_{max}$, $I_{min}$, $\bar{I}$, $T$, and t and communicated these values to a cloud based server every five minutes.

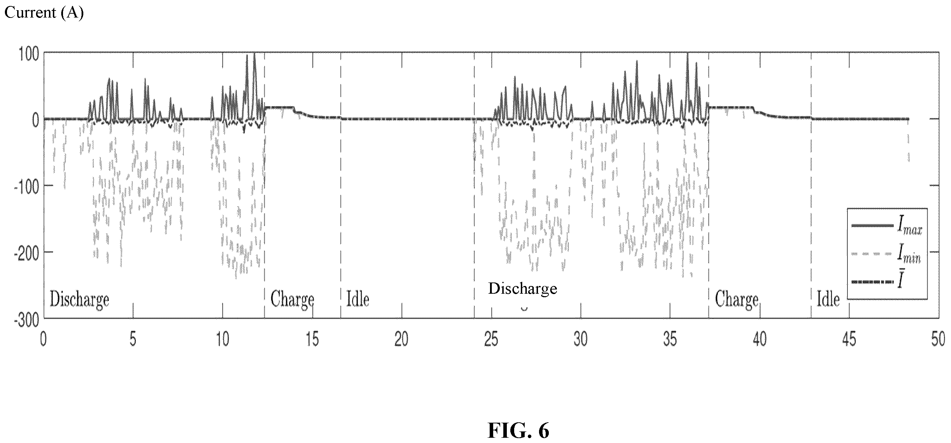

A typical usage profile for the battery string begins with a discharge cycle during the day when the battery experiences irregular use. Usually, in the late evening, the battery is plugged in and charged during the night. Once the charging process is complete, the battery enters an idle state until it is used again. The IOT device detected the state of the battery (Charge, Discharge, and Idle). FIGS. 6-9 show example data for two sequential full battery cycles (discharge and charge) of a field-tested golf cart.

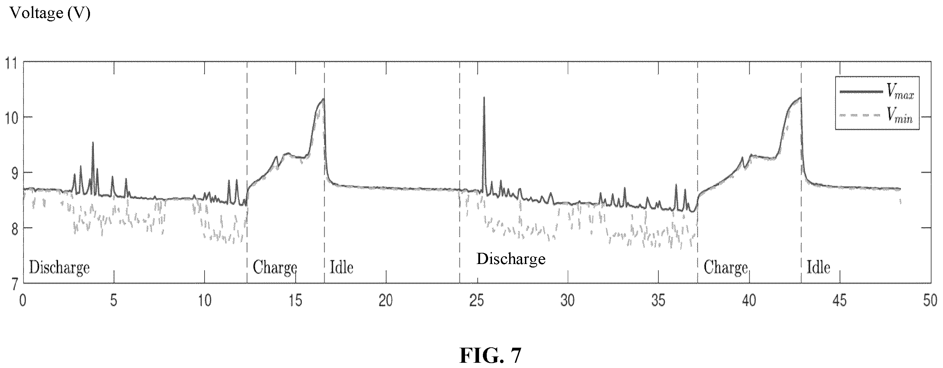

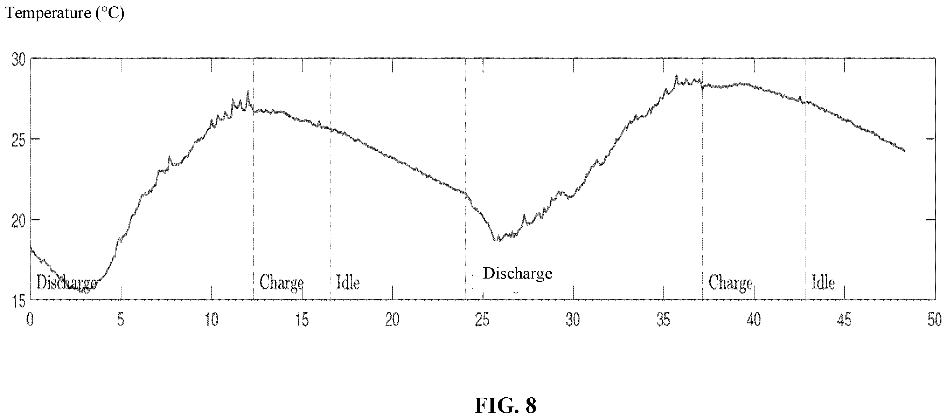

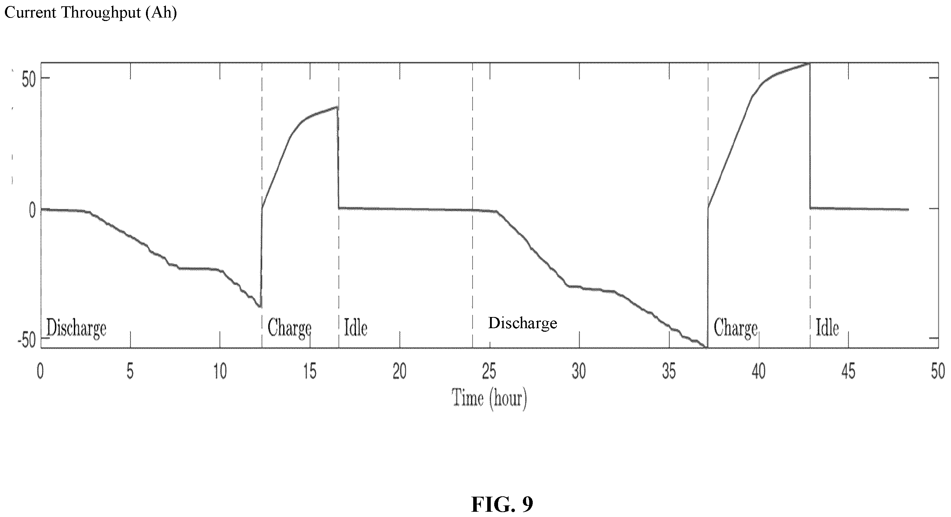

FIG. 6 shows $I_{max}[h]$, $I_{min}[h]$, and the average current $\bar{I}[h]$ over the 5 minute sample period. As expected, the current varies a lot over the 5 minute period. FIG. 7 shows $V_{max}[h]$ and $V_{min}[h]$. Rest or idle periods are clearly visible when $I_{max}[h] \approx I_{min}[h] \approx 0$ and $V_{max}[h] \approx V_{min}[h]$. FIGS. 8 and 9 show the temperature variation and integrated current throughput, respectively. The current throughput was reset to zero at the beginning of charge and idle states.

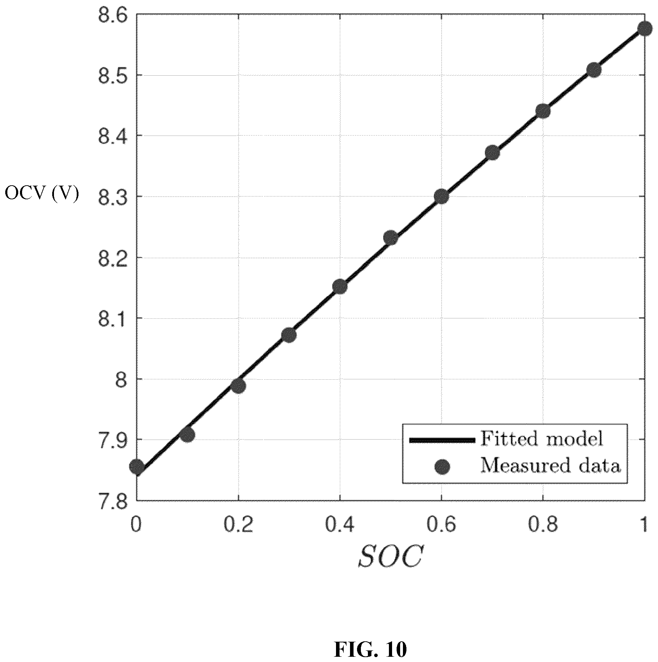

The filter parameters in Table 1 were chosen to select only high quality data based on the golf cart application. The OCV-SOC relationship is shown in FIG. 10. Experimental voltage data is plotted as a function of SOC at C/3 C-rate corresponding to average current during discharge.

**Table 1:** Filter parameters

| Parameter | Used Value |
|---|---|
| $\eta_1$ | 100 (hr) |
| $\eta_2$ | 100 (hr) |
| $\eta_3$ | 200 (hr) |
| $\zeta$ | 30 (Ah) |
| $\alpha$ | 100 (A) |
| $\beta$ | 25 (min) |

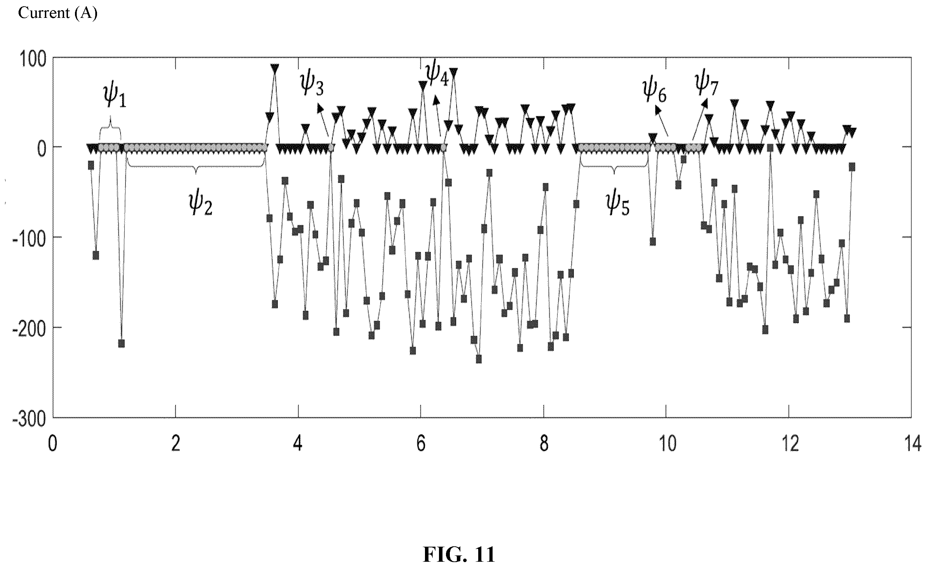

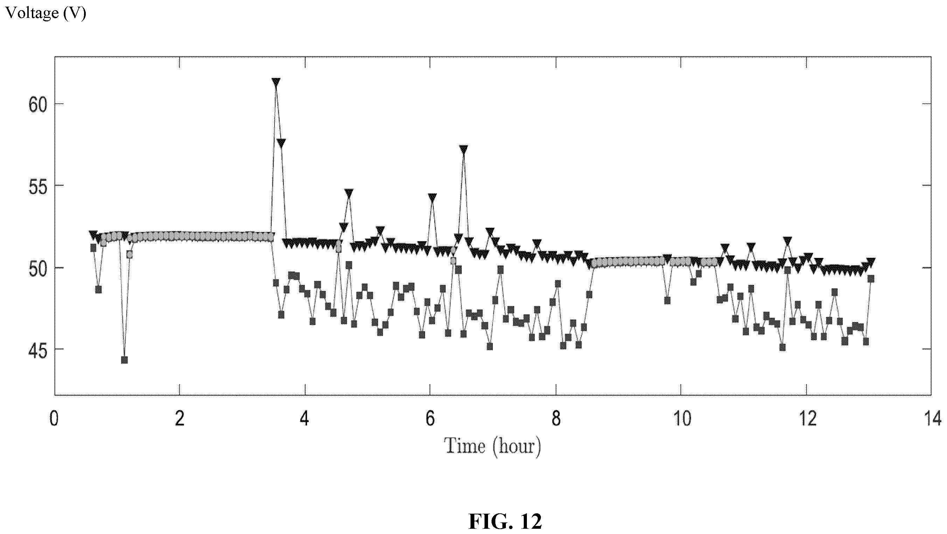

FIGS. 11 and 12 show the maximum, minimum, and rest voltage and current versus time for a typical full discharge cycle of golf cart. Seven rest periods, $\psi_1, \ldots \psi_7$, are identified using the filtering criteria in Equation (1). The filtering criteria $|I_{min}[h] - I_{min}[h-1]| > \alpha$ eliminates $\psi_2$, $\psi_4$, and $\psi_6$ because the current pulses are less than 100 A. The filtering criteria $\psi_j > \beta$ eliminates $\psi_1$, $\psi_2$, $\psi_3$, $\psi_4$, $\psi_6$, and $\psi_7$ because the rest periods are less than 25 minutes. Thus, $\psi_5$ is the sample used for resistance calculation.

For capacity calculation, the voltages at the end of $\psi_2$ and $\psi_7$ were used because the $\Delta Ah$ is maximized and meets the filtering criteria $\Delta Ah > \zeta = 30$ Ah. For capacity estimation, we used rest periods that were sufficiently long to ensure transient decay to match the C/3 rate used in the OCV-SOC curve.

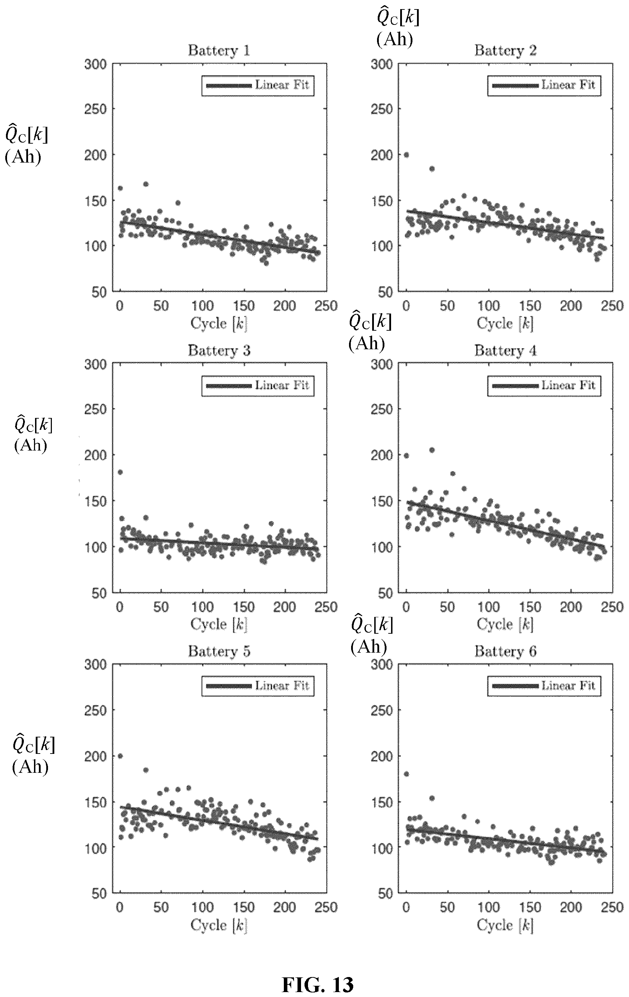

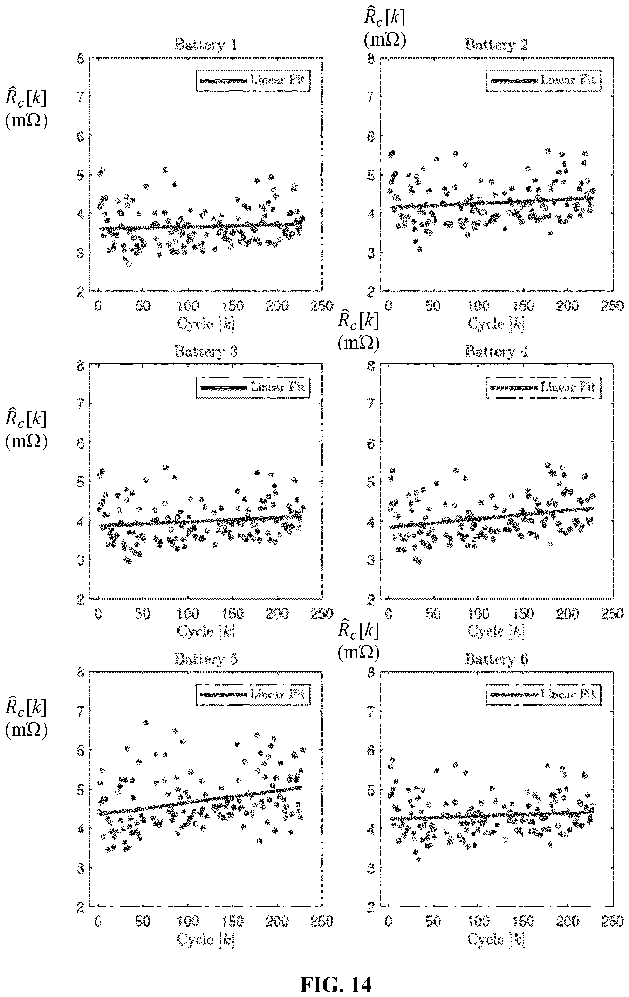

FIGS. 13 and 14 show the estimated capacity and internal resistance versus cycle number (e.g. days), respectively. The capacity estimates in FIG. 13 are tightly clustered and similar for all six batteries. The filtering criteria eliminated 107 days out of 250 because those days did not have rest periods that met the filtering criteria. There are few outliers in the capacity estimates. The best fit lines for all batteries show the expected gradual decrease in capacity over time.

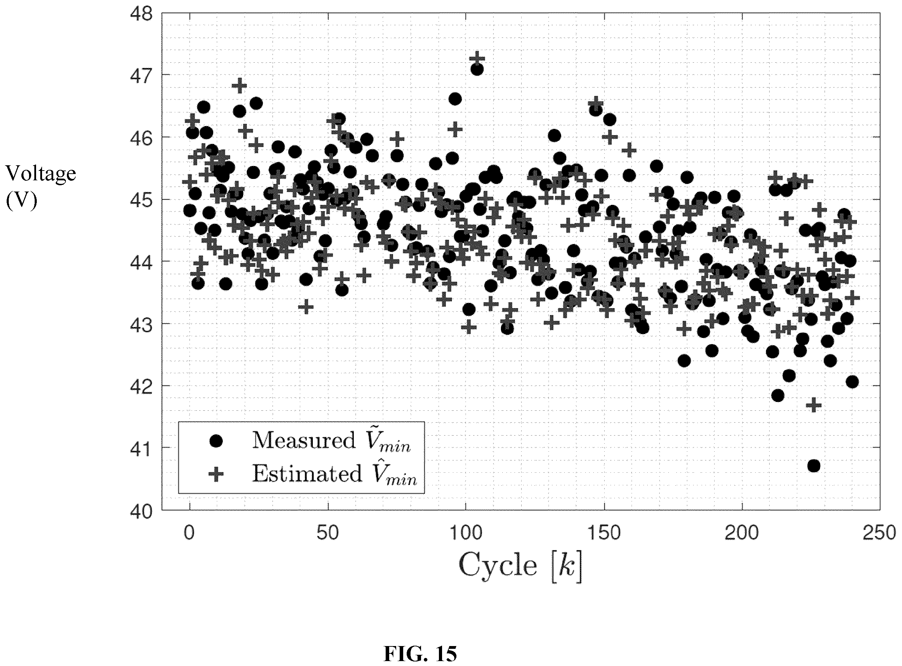

FIG. 15 shows the minimum voltage ($V_{min}$) for each discharge cycle and the estimated $V_{min}$ from Equation (9) over time for the battery string. The estimated and measured $V_{min}$ match well over the 250 days of usage. The RMSE was 0.54 V, around 1% of the string voltage. The accuracy of $V_{min}$ estimation provides evidence that the underlying resistance and capacity estimation algorithms are also producing accurate estimates. Due to the compounding effect of capacity fade and impedance rise, $V_{min}$ decreases at a faster than a linear rate.

It should be understood that modifications to the embodiments disclosed herein can be made to meet a particular set of design criteria. For instance, the number of or configuration of components or parameters may be used to meet a particular objective.

It will be apparent to those skilled in the art that numerous modifications and variations of the described examples and embodiments are possible in light of the above teachings of the disclosure. The disclosed examples and embodiments are presented for purposes of illustration only. Other alternative embodiments may include some or all of the features of the various embodiments disclosed herein. For instance, it is contemplated that a particular feature described, either individually or as part of an embodiment, can be combined with other individually described features, or parts of other embodiments. The elements and acts of the various embodiments described herein can therefore be combined to provide further embodiments.

It is the intent to cover all such modifications and alternative embodiments as may come within the true scope of this invention, which is to be given the full breadth thereof. Additionally, the disclosure of a range of values is a disclosure of every numerical value within that range, including the end points. Thus, while certain exemplary embodiments of the apparatus and process and/or utilization and methods of making and using the same have been discussed and illustrated herein, it is to be distinctly understood that the invention is not limited thereto but may be otherwise variously embodied and practiced within the scope of the following claims.

**Claims**

1. A method of estimating a state of health of a battery (12) of an e-micromobility vehicle (10), the method comprising:

   collecting sensor data of the battery (12) during a plurality of compression periods,
   wherein the sensor data comprises voltage data, current data, and/or temperature data;
   determining parameter data from the collected sensor data for each compression period,
   compressing the parameter data on-board the vehicle (10);
   transmitting the compressed parameter data to an external device (30, 32, 34) for analyzing the compressed parameter data to estimate the state of health (SOH) of the battery (12).

2. The method of claim 1, wherein the external device (30, 32, 34) is selected from the group consisting of an input/output device (30), a server (32), and a charging device (34) and the method includes the external device (30, 32, 34) analyzing the compressed parameter data to estimate the state of health (SOH) of the battery (12) .

3. The method of claim 1 or claim 2, wherein the compressed parameter data comprises at least one of:

   maximum voltage ($V_{max}$),
   minimum voltage ($V_{min}$),
   current at time of maximum voltage ($I_{max}$),
   current at time of minimum voltage ($I_{min}$),
   average current ($\bar{I}$),
   average temperature ($\bar{T}$), and
   time (t) of the compression period.

4. The method of claim 3, wherein the external device (30, 32, 34) is configured to estimate a state of charge (SOC) of the battery (12) by calculating:

$$\widehat{SOC}[h] = f^{-1}(V_{rest})$$

   wherein $\widehat{SOC}$ refers to an estimated state of charge, $h$ refers to a series of compression periods, $f$ refers to an open circuit voltage-SOC (OCV-SOC) curve of the battery, $f^1$ is the inverse function of $f$, and $V_{rest}$ refers to a real-time voltage at the end of a rest period.

5. The method of claim 4, wherein a rest period is identified by a series of compression periods according to:

$$|I_{min}[h]| < \frac{Q}{\eta_1}, \text{ and } |I_{max}[h]| < \frac{Q}{\eta_2}, \text{ and } |\bar{I}[h]| < \frac{Q}{\eta_3}$$

   wherein $Q$ refers to nominal capacity, and $n_{1,2,3}$ refer to rest point limits on $|I_{min}|$, $|I_{max}|$, $|\bar{I}|$, respectively.

6. The method of claim 3, wherein the external device (30, 32, 34) is configured to estimate a state of charge (SOC) of the

battery by calculating:

$$\widehat{SOC}[h] = 1 + \frac{\sum_{h=1}^{N_c} \bar{I}[h](t[h] - t[h-1])}{\hat{Q}_c}$$

wherein $\widehat{SOC}$ refers to an estimated state of charge, $h$ refers to a series of compression periods, $\hat{Q}_c$ refers to an estimated total capacity, and $N_c$ refers to a number of compression periods.

7. The method of claim 3, claim 4, claim 5, or claim 6, wherein the external device (30, 32, 34) is configured to estimate a capacity of the battery ($\hat{Q}_c$) by calculating:

$$\hat{Q}_c = \frac{\sum_{h=h_1}^{h_2} \bar{I}[h](t[h] - t[h-1])}{\widehat{SOC}[h_1] - \widehat{SOC}[h_2]}$$

wherein $\widehat{SOC}$ refers to an estimated state of charge and $h$ refers to a series of compression periods.

8. The method of claim 7, wherein the state of health (SOH) is estimated by calculating:

$$SOH = \frac{\hat{Q}_c}{Q_O} \times 100\%$$

wherein $\hat{Q}_O$ refers to initial capacity *and* $\hat{Q}_c$ refers to current capacity estimate.

9. The method of claim 3, claim 4, claim 5, claim , claim 7 or claim 8, wherein the external device is configured to estimate a resistance of the battery (12) by calculating:

$$\hat{R}_c = \frac{V_{min}[h] - V_{min}[h-1]}{I_{min}[h] - I_{min}[h-1]}$$

wherein $h$ refers to a series of compression periods.

10. The method of claim 9, wherein the state of health is estimated by calculating:

$$SOH = \frac{R_{EOL} - \hat{R}_C}{R_{EOL} - R_O} \times 100\%$$

wherein $R_{EOL}$ refers to resistance at end of life, $\hat{R}_C$ refers to the resistance estimate at current time, and $R_O$ refers to resistance at an initial time.

11. The method of claim 2, comprising:
the charging device (34) adjusting charging of the e-micromobility vehicle (10) based on the estimated state of health (SOH).

12. A system for estimating a state of health (SOH) of a battery (12) of an e-micromobility vehicle (10), the system comprising:
a battery management system (14) comprising a microcontroller unit (16), a non-transitory computer readable medium (18) connected to the microcontroller unit (16), a communication unit (20) connected to the microcontroller unit (16), and a sensor array (22) connected to the microcontroller unit (16),

wherein the sensor array (22) comprises a voltage sensor (22a), a current sensor (22b), and a temperature sensor (22c),

wherein the sensor array (22) is configured to collect sensor data of the battery (12) during a plurality of compression periods, wherein the sensor data comprises voltage data, current data, and temperature data collected from the voltage sensor (22a), the current sensor (22b), and the temperature sensor (22c);

wherein the battery management system (14) is configured to determine parameter data from collected sensor data for each compression period,

wherein the battery management system (14) is configured to compress the parameter data on-board the vehicle (10) to send the compressed data to an external device (30, 32, 34) that is configured to receive the compressed parameter data from the battery management system (14).

13. The system of claim 12, including the external device (30, 32, 34), wherein the external device (30, 32, 34) is configured to estimate the state of health (SOH) of the battery (12), and wherein the external device (30, 32, 34) is selected from the group consisting of an input/output device (30), a server (32), and a charging device (34).

14. The system of claim 12 or claim 13, wherein the system is configured to implement the method of any of claims 1-11.

15. The system of claim 14, wherein the external device includes the charging device (34) and the charging device (34) is configured to adjust charging of the battery (12) of the e-micromobility vehicle (10) based on the state of health estimate.

FIG. 1

EP 4 703 749 A1

**FIG. 2A**

**FIG. 2B**

**FIG. 3A**

**FIG. 3B**

**FIG. 3C**

FIG. 4

EP 4 703 749 A1

FIG. 5

EP 4 703 749 A1

Current (A)

**FIG. 6**

FIG. 7

Temperature (°C)

FIG. 8

Current Throughput (Ah)

**FIG. 9**

EP 4 703 749 A1

**FIG. 10**

**FIG. 11**

**FIG. 12**

$\hat{Q}_C[k]$
(Ah)

Battery 1

$\hat{Q}_C[k]$
(Ah)

Battery 2

Battery 3

$\hat{Q}_C[k]$
(Ah)

Battery 4

$\hat{Q}_C[k]$
(Ah)

Battery 5

$\hat{Q}_C[k]$
(Ah)

Battery 6

**FIG. 13**

**FIG. 14**

**FIG. 15**

Europäisches
Patentamt

European
Patent Office

Office européen
des brevets

# EUROPEAN SEARCH REPORT

**Application Number**

EP 24 22 1254

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br>A | US 2024/241180 A1 (LEE JUNG HOON [KR]) 18 July 2024 (2024-07-18)<br>* figures 1-5 * | 1-3, 11-15<br>4-10 | INV.<br>G01R31/371<br>G01R31/392 |
| X | US 2018/120384 A1 (KALLFELZ ANDREW F [US] ET AL) 3 May 2018 (2018-05-03)<br>* paragraph [0092] - paragraph [0099]; figures 1, 4 * | 1,12 | |
| X | CN 117 706 402 B (SHIJIAZHUANG DEVELOPMENT ZONE TIANYUAN TECH CO LTD) 14 June 2024 (2024-06-14)<br>* English translation, page 8, 3rd para., to page 6, 6th para.; figures 1-3 * | 1,12 | |

**TECHNICAL FIELDS SEARCHED (IPC)**

G01R

The present search report has been drawn up for all claims

| Place of search | Date of completion of the search | Examiner |
|---|---|---|
| Munich | 22 May 2025 | Agerbaek, Thomas |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.......................................................................................................

& : member of the same patent family, corresponding
    document

EPO FORM 1503 03.82 (P04C01)

2

## ANNEX TO THE EUROPEAN SEARCH REPORT
## ON EUROPEAN PATENT APPLICATION NO.

EP 24 22 1254

This annex lists the patent family members relating to the patent documents cited in the above-mentioned European search report.
The members are as contained in the European Patent Office EDP file on
The European Patent Office is in no way liable for these particulars which are merely given for the purpose of information.

22-05-2025

| Patent document cited in search report | | Publication date | Patent family member(s) | | Publication date |
|---|---|---|---|---|---|
| US 2024241180 | A1 | 18-07-2024 | CN | 117396767 A | 12-01-2024 |
| | | | EP | 4386401 A1 | 19-06-2024 |
| | | | JP | 7658464 B2 | 08-04-2025 |
| | | | JP | 2024519755 A | 21-05-2024 |
| | | | KR | 20230025130 A | 21-02-2023 |
| | | | US | 2024241180 A1 | 18-07-2024 |
| | | | WO | 2023018070 A1 | 16-02-2023 |
| US 2018120384 | A1 | 03-05-2018 | US | 2014374475 A1 | 25-12-2014 |
| | | | US | 2018120384 A1 | 03-05-2018 |
| CN 117706402 | B | 14-06-2024 | NONE | | |

For more details about this annex : see Official Journal of the European Patent Office, No. 12/82